# EUROPEAN PATENT APPLICATION

(11) **EP 4 328 964 A1**
(43) Date of publication of application: **28.02.2024**
(21) Application number: 23191710.5
(22) Date of filing: 16.08.2023
(51) Int. Cl.: H01L 23/367, H01L 23/467, H05K 7/20

(54) **HEAT SINK ASSEMBLY**

(30) Priority: 25.08.2022 NL 2032852
(71) Applicant: Poynting Antennas (Pty) Limited, 0157 Pretoria (ZA)
(72) Inventor: FOURIE, Andries Petrus Cronje, 2193 Parkview (ZA); MUNDY, Shane Michael, 0157 Gauteng (ZA)
(74) Representative: Maiwald GmbH

(57) **Abstract**

A heatsink assembly 10 comprises a heat conductive base 12 having a surface 14. The assembly further comprises at least a first heat conductive plate 16 and a second heat conductive plate 18. A first heat conductive spacer 20 is sandwiched between the surface and the first plate. The first spacer holds the first plate parallel to and in spaced relationship relative to the surface, to define a first passage 22 for a cooling fluid medium between the surface and the first plate. A second heat conductive spacer 24 is sandwiched between the first plate and the second plate. The second spacer holds the second plate parallel to and in spaced relationship relative to the first plate, to define a second passage 26 for the cooling medium. A link 28 connects the first plate, the second plate, the first spacer and the second spacer in heat exchanging relationship to the base.

## Description

### INTRODUCTION AND BACKGROUND

This invention relates to a heatsink assembly.

Heatsinks for electronic equipment are well known in the art. A heatsink is a passive heat exchanger that transfers heat generated by electronic or mechanical equipment to a fluid medium, often air or a liquid coolant, where it is dissipated away from the device, thereby allowing regulation of the equipment's temperature. Normally, a heatsink is designed to maximize its surface area in contact with the cooling fluid medium. Known heatsink configurations include a pin-fin heatsink which is a heatsink that has pins formed integrally with a base and which extend from the base. The pins can be cylindrical, elliptical or square. A second type of heatsink fin arrangement is the straight fin. These fins are also integrally formed with the base and extend orthogonally from the base and run the entire length of the base. A variation on the straight-fin heatsink is a cross-cut heatsink where the fins of a straight-fin heatsink is interrupted at regular intervals. Air velocity, choice of material, protrusion design and surface treatment are factors that affect the performance of a heatsink. The above heatsinks are not efficient enough and/or not aesthetically acceptable for at least some applications.

### OBJECT OF THE INVENTION

Accordingly, it is an object of the present invention to provide a heatsink assembly with which the applicant believes the aforementioned disadvantages may at least be alleviated or which may provide a useful alternative for the known arrangements.

### SUMMARY OF THE INVENTION

According to the invention there is provided a heatsink assembly comprising:
- a heat conductive base having a surface;
- at least a first heat conductive plate and a second heat conductive plate;
- a first heat conductive spacer sandwiched between the surface and the first plate, the first spacer holding the first plate parallel to and in spaced relationship relative to the surface to define a first passage for a cooling fluid medium between the surface and the first plate;
- a second heat conductive spacer sandwiched between the first plate and the second plate, the second spacer holding the second plate parallel to and in spaced relationship relative to the first plate to define a second passage for the cooling medium between the first plate and the second plate; and
- a link for connecting the first and second plates and the first and second spacers in heat exchanging relationship to the base.

The heatsink assembly may comprise a third heat conductive plate and a third heat conductive spacer sandwiched between the second plate and the third plate, the third spacer holding the third plate parallel to and in spaced relationship relative to the second plate to define a third passage for the cooling medium between the second plate and the third plate.

The surface may be flat or planar.

The first and second spacers may be disc-shaped, may have opposed abutment faces and may define a respective centre eye.

The first and second disc-shaped spacers may be mounted with the respective eyes in register.

A surface area of the opposed abutment faces of the second spacer may be larger than the corresponding faces of the first spacer.

In general, opposed abutment faces of an n^{th} spacer may be lager that the corresponding faces of an (n-1)^{th} spacer. Hence, the surface area of opposed abutment faces of the spacers in the assembly may increase with the distance of the spacer from the surface of the base.

The link may comprise a bolt having a shank extending through the respective registering eyes and registering holes in the first plate and the second plate.

The at least first and second plates may define a respective aperture and the plates are arranged such that the respective apertures are in register to define a passage through the assembly for the cooling medium which passage extends transversely the first passage.

According to another aspect of the invention there is provided a heatsink assembly comprising:
- a heat conductive base having a surface;
- at least a first heat conductive plate and a second heat conductive plate;
- the first plate extending parallel to and in spaced relationship relative to the surface to define a first passage for a cooling fluid medium between the surface and the first plate;
- the second plate extending parallel to and in spaced relationship relative to the first plate to define a second passage for the cooling medium between the first plate and the second plate; and
- at least one heat conductive link extending between the base and at least one of the first plate and the second plate.

### BRIEF DESCRIPTION OF THE ACCOMPANYING DIAGRAMS

The invention will now further be described, by way of example only, with reference to the accompanying diagrams wherein:
- figure 1: is a diagrammatic perspective view of an example embodiment of a heatsink assembly as part of an antenna dome assembly;
- figure 2: is a vertical section through the assembly in figure 1;
- figure 3: is a diagrammatic perspective view of the antenna dome assembly from below;
- figure 4: is an exploded perspective view of the antenna dome assembly comprising the heatsink assembly;
- figure 5: is another exploded perspective view of the antenna dome assembly;
- figure 6: is a perspective view from above of the heatsink assembly;
- figure 7: is a plan view of the heatsink assembly;
- figure 8: is a section on line VIII - VIII' in figure 7;
- figure 9: is a section on line IX - IX' in figure 7;
- figure 10: is a section on line X - X' in figure 7; and
- figure 11: is a diagrammatic perspective view of a spacer forming part of the heatsink assembly.

### DESCRIPTION OF A PREFERRED EMBODIMENT OF THE INVENTION

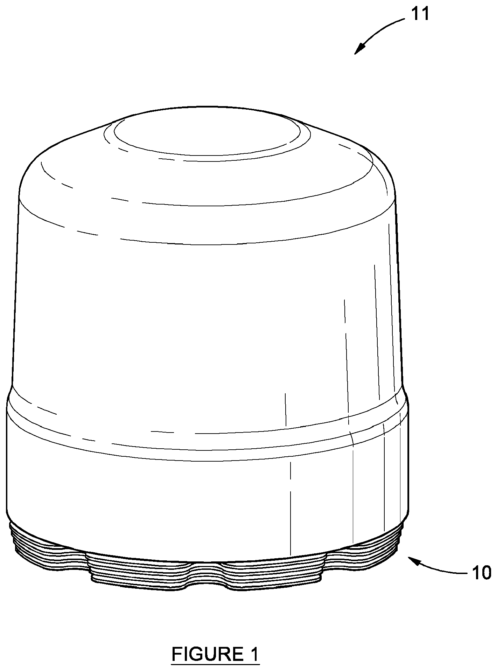

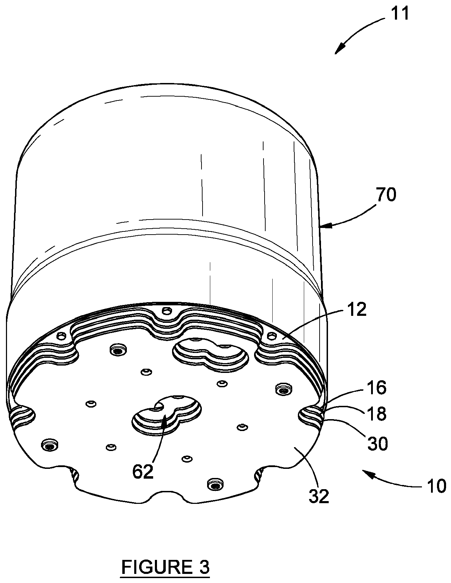

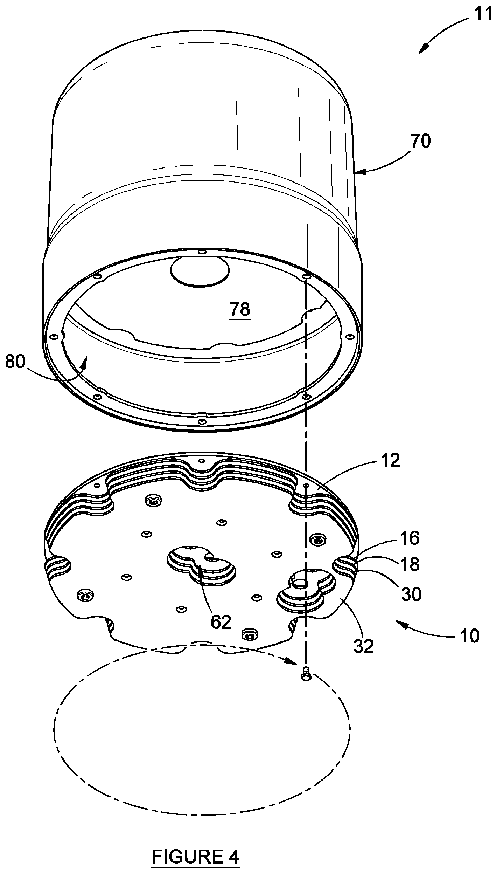

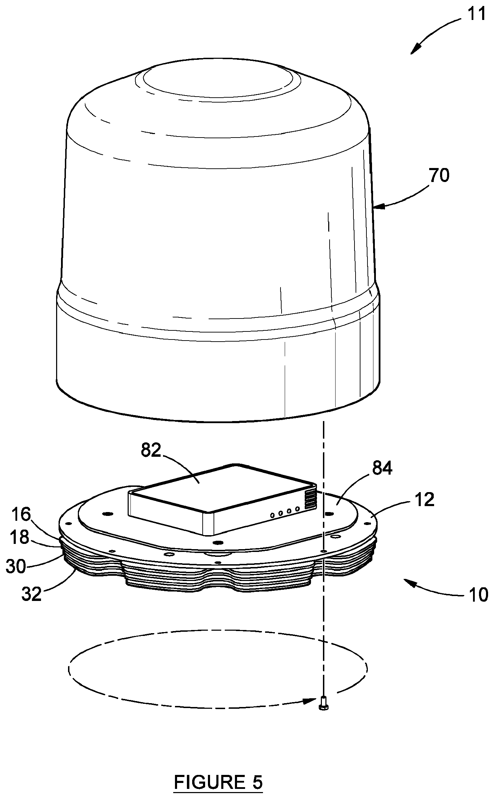

An example embodiment of a heatsink assembly is generally designated by the reference number 10 in the figures 1 to 8. In this example embodiment, the heatsink assembly 10 forms part of an antenna dome assembly 11.

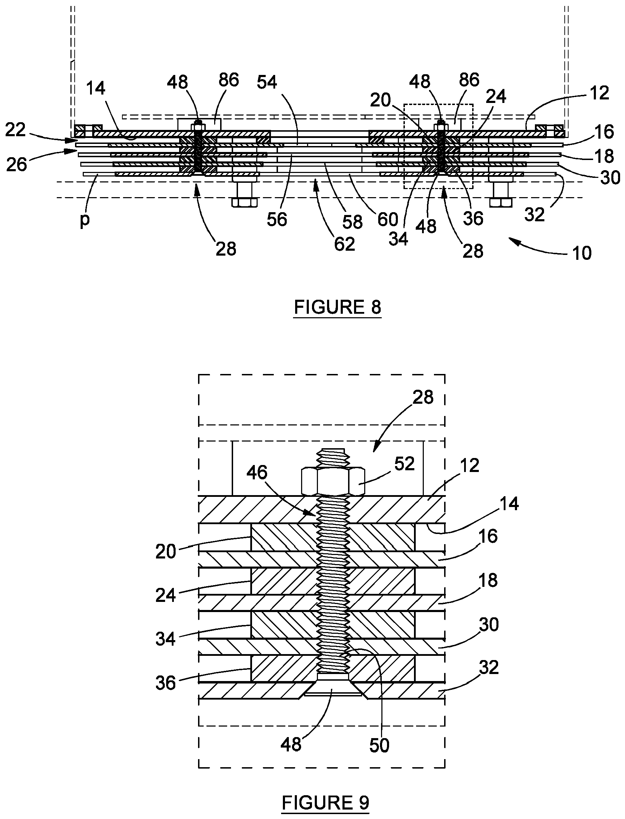

The heatsink assembly 10 comprises a heat conductive base 12 having a surface 14. The assembly further comprises at least a first heat conductive plate 16 and a second heat conductive plate 18. A first heat conductive spacer 20 is sandwiched between the surface 14 and the first plate 16. The first spacer 20 holds the first plate 16 parallel to and in spaced relationship relative to the surface 14, to define a first passage 22 for a cooling fluid medium (not shown) between the surface 14 and the first plate 16. A second heat conductive spacer 24 is sandwiched between the first plate 16 and the second plate 18. The second spacer 24 holds the second plate 18 parallel to and in spaced relationship relative to the first plate 16, to define a second passage 26 for the cooling medium between the first plate 16 and the second plate 18. A link 28 (best shown in figures 8 and 9) connects the first plate 16, the second plate 18, the first spacer 20 and the second spacer 24 in heat exchanging relationship to the base 12.

The heatsink assembly 10 may comprise any suitable number of parallel heat conductive plates, such as four plates 16, 18, 30, 32 shown in the diagrams. As best shown in figure 9, a third plate 30 is spaced from the second plate 18 by a heat conductive spacer 34 and a fourth plate 32 is spaced from the third plate by a heat conductive spacer 36. The link 28 connects all of the heat conducive plates and heat conductive spacers in heat exchanging relationship with the base 12.

The surface 14 is typically, but not necessarily, flat or planar, as shown in the diagrams. In such embodiments the, plates would also be flat. In other embodiments, the surface and the plates may be curved.

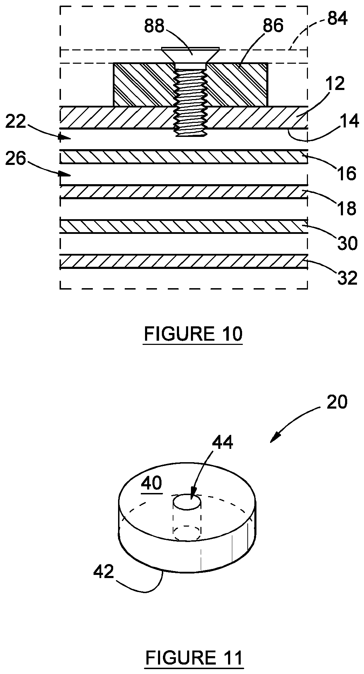

An example embodiment of a spacer, in this case spacer 20, is shown in figure 11. The spacer 20 is circular in configuration and disk-shaped having opposed abutment faces 40 and 42 and defining a centre eye 44. Face 40 abuts surface 14 and face 42 abuts the first plate 16. The other spacers are preferably similar in configuration. Opposed abutment faces of an n^{th} spacer may be lager that the corresponding faces of an (n-1)^{th} spacer. Hence, the surface area of opposed abutment faces of the spacers in the assembly may increase with the distance of the spacer from the surface 14 of the base 12.

Referring to figure 9, the link 28 may comprise a bolt 46 having a head 48 and a threaded shank 50. A nut 52 cooperates with the threaded shank. As best shown in figures 8 and 9, the base 12, the plates 16, 18, 30 and 32 and the spacers 20, 24, 34 and 36 are tightly sandwiched between the head 48 and the nut 52.

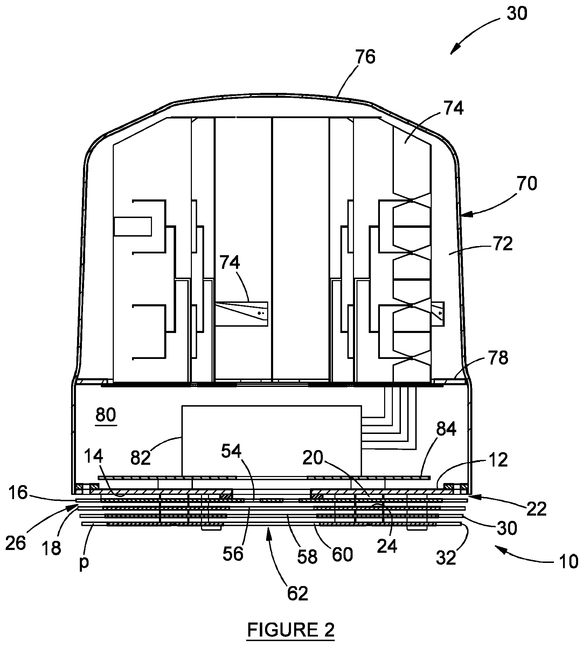

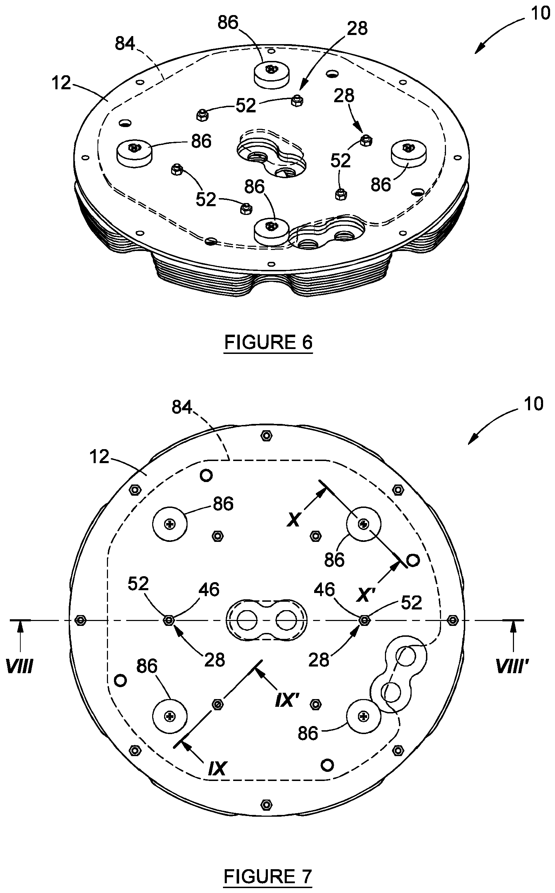

As best shown in figures 2 to 8, the base 12 may be circular in configuration and, as shown in figure 6, more than one (in this case six) radially equi-spaced links 28 in the form of respective nut and bolt assemblies 52, 46 are used to sandwich radially equi-spaced regions of the plates and the spacers as described above.

As shown in figures 2 and 8, each of the plates 16, 18, 30 and 32 may define a respective centre aperture 54, 56, 58 and 60, so that a passage 62 transversely the first and second passages 22 and 26 is defined through the heatsink assembly 10.

The base 12, plates 16, 18, 30 and 32, and the spacers 20, 24, 34 and 36 are made of any suitable heat conductive material, such a metal, typically aluminium. The plates and/or spacers may be cut or stamped or machined and no moulding may be required. Relevant surfaces of the above elements may be powder coated.

In the example embodiment and as best shown in figure 2, the heatsink assembly 10 forms part of an antenna dome assembly 11. The dome assembly comprises a dome 70 defining a first chamber 72 for antennas 74. The configuration of the antennas and their arrangement in the first chamber are explained in detail in the applicant's co-pending Dutch priority founding application entitled "Antenna Dome Assembly", which has the same priority date as this application and the contents of which are incorporated herein by this reference. The first chamber 72 is defined between a crown region 76 and a heat insulating floor 78 inside the dome. A second chamber 80 for electronic equipment, such as a MIMO router 82 is defined between the floor 78 and the heatsink assembly 10.

As best shown in figures 2, 5 to 8 and 10 the electronic equipment 82 is mounted on a platform 84 in the second chamber. The platform 84 is spaced by spacers 86 from the base 12 and, as shown in figure 10, is mounted on the base by screws 88 extending through eyes in the spacers 86.

## Claims

1. A heatsink assembly comprising:
- a heat conductive base having a surface;
- at least a first heat conductive plate and a second heat conductive plate;
- a first heat conductive spacer sandwiched between the surface and the first plate, the first spacer holding the first plate parallel to and in spaced relationship relative to the surface to define a first passage for a cooling fluid medium between the surface and the first plate;
- a second heat conductive spacer sandwiched between the first plate and the second plate, the second spacer holding the second plate parallel to and in spaced relationship relative to the first plate to define a second passage for the cooling medium between the first plate and the second plate; and
- a link for connecting the first and second plates and the first and second spacers in heat exchanging relationship to the base.

2. The heatsink assembly of claim 1 comprising at least a third heat conductive plate and a third heat conductive spacer sandwiched between the second plate and the third plate, the third spacer holding the third plate parallel to and in spaced relationship relative to the second plate to define a third passage for the cooling medium between the second plate and the third plate.

3. The heatsink assembly of any one of claim 1 and claim 2 wherein the surface is flat.

4. The heatsink assembly of any one of claims 1 to 3 wherein the first and second spacers are disc-shaped and define a respective centre eye.

5. The heatsink assembly of claim 4 wherein the first and second disc-shaped spacers are mounted with the respective eyes in register.

6. The heatsink assembly of claim 5 wherein the link comprises a bolt having a shank extending through the respective registering eyes and registering holes in the first plate and the second plate.

7. The heatsink assembly of any one of claims 1 to 6 wherein a surface area of opposed abutment faces of an n^{th} spacer in the assembly is larger than opposed abutment faces of an (n-1)^{th} spacer in the assembly.

8. The heat sink assembly as claimed in any one of claims 1 to 7 wherein the at least first and second plates define a respective aperture and wherein the plates are arranged such that the respective apertures are in register to define a passage through the assembly for the cooling medium which passage extends transversely the first passage.

9. A heatsink assembly comprising:
- a heat conductive base having a surface;
- at least a first heat conductive plate and a second heat conductive plate;
- the first plate extending parallel to and in spaced relationship relative to the surface to define a first passage for a cooling fluid medium between the surface and the first plate;
- the second plate extending parallel to and in spaced relationship relative to the first plate to define a second passage for the cooling medium between the first plate and the second plate; and
- at least one heat conductive link extending between the base and at least one of the first plate and the second plate.
